# EUROPEAN PATENT APPLICATION

(11) **EP 4 687 293 A1**
(43) Date of publication of application: **04.02.2026**
(21) Application number: 25191565.8
(22) Date of filing: 24.07.2025
(51) Int. Cl.: H03K 17/041, H03K 17/0412, H03K 17/785

(54) **CIRCUIT ARRANGEMENT FOR DISCHARGING AN ELECTRICAL COMPONENT**

(30) Priority: 29.07.2024 DE 102024121542
(71) Applicant: TE Connectivity Solutions GmbH, 8200 Schaffhausen (CH); TE Connectivity KISSLING Products GmbH, 72218 Wildberg (DE)
(72) Inventor: HERTZBERG, Thomas, 8200 Schaffhausen (CH); KALMBACH, Simon, 72218 Wildberg (DE); UNTERHINNINGHOFEN, Ulrich, 8200 Schaffhausen (DE)
(74) Representative: Grünecker Patent- und Rechtsanwälte PartG mbB

(57) **Abstract**

The present invention comprises a circuit arrangement (100) for discharging an electrical component. The circuit arrangement (100) comprises a photovoltaic isolation unit (140), which is arranged on a first side between a first input terminal (105) and a second input terminal (110) and is arranged on a second side between a first intermediate node (106) and a second intermediate node (107). Further, the circuit arrangement (100) comprises a first Zener diode (142) arranged between the first intermediate node (106) and the second intermediate node (107); a first resistor unit (150) arranged between the first intermediate node (106) and a first connection point (162); an intermediate circuit (145) arranged between the first connection point (162), a second connection point (164), a third connection point (166) and a fourth connection point (168); a first switching element (160) which is arranged between the third connection point (166), a third intermediate node (108) and a first output terminal (122); and a first resistor (144) which is arranged between a first voltage terminal (120) and the third intermediate node (108).

## Description

The present invention relates to a circuit arrangement for discharging an electrical component.

Electronic components that are operated with voltage or are under voltage must be able to be discharged in certain situations such as system faults, accidents or when required. This is relevant for vehicle electrical systems, for example. The components under low voltage should typically be discharged to a voltage value below 60 V.

Common solutions use a relay that discharges the low voltage in a closed state. In the normal state, a low voltage keeps the relay actively open so that no discharge takes place. If a fault occurs or the control voltage of the relay drops out for other reasons, the relay closes and thus also the discharge path.

However, such solutions have the disadvantage that the built-in relays are subject to wear due to the mechanical opening and closing and the functionality can also be disrupted by vibrations. In addition, with such solutions, a current must flow continuously at the control signal to keep the relay open. This increases the quiescent current of the system.

There is therefore a need for an improved circuit arrangement that provides a reliable discharge when the control voltage is removed and at the same time offers an efficient and cost-effective solution.

This problem is solved by the subject matter of the independent claims. Advantageous embodiments of the present invention are the subject of the dependent claims.

The invention comprises the idea of replacing the known relay with an electrical circuit arrangement that is no longer subject to detrimental mechanical wear.

In particular, the present invention comprises a circuit arrangement for discharging an electrical component. Thereby, the circuit arrangement comprises a photovoltaic isolation unit arranged on a first side between a first input terminal and a second input terminal and arranged on a second side between a first intermediate node and a second intermediate node. Furthermore, the circuit arrangement comprises a first Zener diode, a first resistor unit, an intermediate circuit, a first switching element and a first resistor. The first Zener diode is arranged between the first intermediate node and the second intermediate node, and the first resistor unit is arranged between the first intermediate node and a first connection point. The intermediate circuit is arranged between the first connection point, a second connection point, a third connection point and a fourth connection point. The first switching element is arranged between the third connection point, a third intermediate node and a first output terminal, and a first resistor is arranged between a first voltage terminal and the third intermediate node.

The circuit arrangement according to the present invention enables an electrical component to be discharged. Preferably, discharging takes place when there is no control voltage at the input terminals (control side). In particular, the control side is electrically isolated from the side to be discharged. An electrical component to be discharged within the meaning of the present invention can, for example, also be an electrical network whose capacitive elements are to be discharged. In this respect, the present circuit arrangement enables efficient switching of the switching elements, which reduces the switching losses of the circuit. In addition, the arrangement of the first Zener diode in particular serves to protect the photovoltaic isolation unit from excessive voltages in the event of a fault. As an example, the Zener voltage of the first Zener diode is between 8.5 V and 9.5 V, in particular 9.1 V.

According to an advantageous further embodiment of the present invention, the first resistor unit comprises a second resistor, a third resistor and a fourth resistor.

The advantageous arrangement of the first resistor unit ensures that the current is limited on one side of the photovoltaic isolation unit. In particular, the second resistor, the third resistor and the fourth resistor are high-impedance resistors, such as having a value greater than 1 MOhm. This advantageously ensures that the current at the photovoltaic isolation unit cannot rise above 500 µA, in particular not above 300 µA.

According to an advantageous further development, the first switching element comprises a silicon carbide metal-oxide semiconductor field effect transistor (SiC-MOSFET), or an insulated gate bipolar transistor (IGBT), or a junction field effect transistor (JFET). In particular, the first switching element comprises a fast-switching switching element.

According to an advantageous embodiment, the second connection point is connected to a second voltage terminal, and the fourth connection point is connected to a ground terminal.

According to an advantageous embodiment, the photovoltaic isolation unit is a photovoltaic optoisolator. Photovoltaic optoisolators enable a high degree of isolation and thus offer a safe solution for galvanic isolation of a control side and a load side.

According to an advantageous embodiment, the second voltage terminal and/or the first voltage terminal are a load voltage terminal. According to an advantageous embodiment, the first input terminal and the second input terminal are a control voltage terminal. A low voltage is preferably provided via the load voltage terminal and an extra-low voltage via the control voltage terminal. The term low voltage in the sense of the present invention means a voltage with a value above 100 V, preferably the value of the low voltage is between 650 V and 1250 V. In particular, the term low voltage serves to distinguish it from extra-low voltage. The value of the low voltage should be higher than the value of the extra-low voltage. An extra-low voltage is a voltage with a voltage value below 100 V, in particular not above 60 V. In particular, the value of the extra-low voltage is below 5 V for certain applications. However, it is clear that other values for the low voltage and the extra-low voltage are also possible. Preferably, the extra-low voltage is present on the control side of the circuit arrangement and the low voltage on the load side.

According to an advantageous embodiment, the first output terminal is connected to the ground terminal.

According to an advantageous further development of the present invention, the intermediate circuit comprises a second resistor unit, a second switching element and a second Zener diode. In this case, the second resistor unit is arranged between the second connection point and the third connection point and the second switching element is arranged between the first connection point, the third connection point and the fourth connection point. The second Zener diode is arranged between the third connection point and the fourth connection point. In particular, the intermediate circuit accelerates the charging and discharging of the gate of the first switching element. As a result, the first switching element is advantageously ready for a new switching operation more quickly. The faster charging and discharging has the advantageous effect that the first switching element can switch between the blocking state and the switched state with lower switching losses. The second Zener diode is advantageously selected such that it has a Zener voltage of more than 15 V, in particular 16 V, for example. In particular, the value of the Zener voltage is selected in such a way that the gate of the first switching element is protected from excessively high voltages.

According to an advantageous embodiment, the second resistor unit comprises a fifth resistor, a sixth resistor and a seventh resistor.

The second resistor unit advantageously provides current limiting in the intermediate circuit. In particular, the fifth resistor, the sixth resistor and the seventh resistor are high-impedance resistors, such as having a value greater than 1 MOhm. The advantageous arrangement of the second resistor unit together with the second Zener diode in the form of a voltage divider also protects the first switching element and, in particular, the gate of the first switching element from excessively high voltages. In particular, this protects the first switching element from the voltage applied to the gate of the first switching element via the second connection point of the second voltage terminal.

According to an advantageous embodiment, the second switching element comprises a silicon carbide metal-oxide semiconductor field effect transistor (SiC-MOSFET), or an insulated gate bipolar transistor (IGBT) or a junction field effect transistor (JFET), or a bipolar transistor, such as an NPN bipolar transistor or a PNP bipolar transistor.

According to a further advantageous further development of the present invention, the intermediate circuit comprises a second resistor unit, a second switching element and an acceleration circuit. In this case, the second resistor unit is arranged between the second connection point and a fourth intermediate node and the second switching element is arranged between the first connection point, the fourth intermediate node and the fourth connection point. The acceleration circuit is arranged between the fourth intermediate node, the third connection point and the fourth connection point. Advantageously, the acceleration circuit improves the charging and discharging of the gate of the first switching element and thus improves the switching speed of the first switching element. This reduces the switching losses in the circuit arrangement.

According to an advantageous embodiment, the second resistor unit comprises a fifth resistor, a sixth resistor and a seventh resistor. The second resistor unit advantageously provides current limiting in the intermediate circuit. In particular, the fifth resistor, the sixth resistor and the seventh resistor are high-impedance resistors, such as having a value greater than 1 MOhm.

According to an advantageous further development of the present invention, the acceleration circuit comprises a capacitor, an eighth resistor, a ninth resistor, a third switching element, a tenth resistor, an eleventh resistor, a third Zener diode, a fourth Zener diode, a fourth switching element, an eleventh resistor, a fifth switching element and a sixth switching element. The capacitor is arranged between the fourth intermediate node and the fourth connection point and the eighth resistor is arranged between the fourth intermediate node and a seventh intermediate node. The ninth resistor is arranged between the fourth intermediate node and a fifth intermediate node and the third switching element is arranged between the seventh intermediate node, a sixth intermediate node and the third connection point. The tenth resistor is arranged between the seventh intermediate node and the sixth intermediate node and the third Zener diode is arranged between the fourth intermediate node and an eighth intermediate node. The fourth Zener diode is arranged between the eighth intermediate node and the third connection point and the fourth switching element is arranged between the sixth intermediate node, the eighth intermediate node and the tenth intermediate node. The eleventh resistor is arranged between the tenth intermediate node and the fourth connection point and the fifth switching element is arranged between the fifth intermediate node, a ninth intermediate node and an eleventh intermediate node. The sixth switching element is arranged between the fifth intermediate node, the third intermediate node and the ninth intermediate node. The twelfth resistor is arranged between the eleventh intermediate node and the fourth connection point.

The advantageous embodiment of the acceleration circuit not only enables faster charging of the gate of the switching element and thus faster and improved switching on of the switching element, but also advantageously improves the switching off of the switching element. The discharge of the gate of the switching element is advantageously accelerated by the acceleration circuit, which reduces the switching losses of the switching element. The increased switching speed of the switching element can also shorten the time between two switching operations.

Values for the components of the acceleration circuit are given below as examples. It is clear that these values are merely examples and represent a possible implementation of the circuit. They are for the purpose of understanding only and are in no way restrictive. By way of example, the capacitor has a value between 8 nF and 12 nF, the third Zener diode has a value between 15 V and 20 V by way of example, and the fourth Zener diode has a value between 10 V and 15 V by way of example. Furthermore, the eighth resistor and/or the ninth resistor have exemplary values between 35 Ohm and 60 Ohm, but do not need necessarily have to have the same value. The tenth resistor preferably has a value between 80 kOhm and 130 kOhm. The eleventh resistor and/or the twelfth resistor have, by way of example, a value between 3 Ohms and 6 Ohms, but do not need necessarily have to have the same value.

Advantageously, the third switching element and/or the fourth switching element and/or the fifth switching element and/or the sixth switching element comprise a silicon carbide metal-oxide semiconductor field effect transistor (SiC-MOSFET), or a junction field effect transistor (JFET) or an insulated gate bipolar transistor (IGBT) or an NPN bipolar transistor or a PNP bipolar transistor.

For a better understanding of the present invention, it is explained in more detail with reference to the embodiments shown in the following figures. The same parts are provided with the same reference signs and the same component designations. Furthermore, some features or combinations of features from the different embodiments shown and described may represent independent inventive solutions or solutions according to the invention. It shows:
- **Fig. 1**: shows a circuit arrangement according to the present invention;
- **Fig. 2**: shows an intermediate circuit according to a first embodiment of the present invention;
- **Fig. 3**: shows the intermediate circuit according to a second embodiment of the present invention;
- **Fig. 4**: shows a photovoltaic optoisolator according to the present invention.

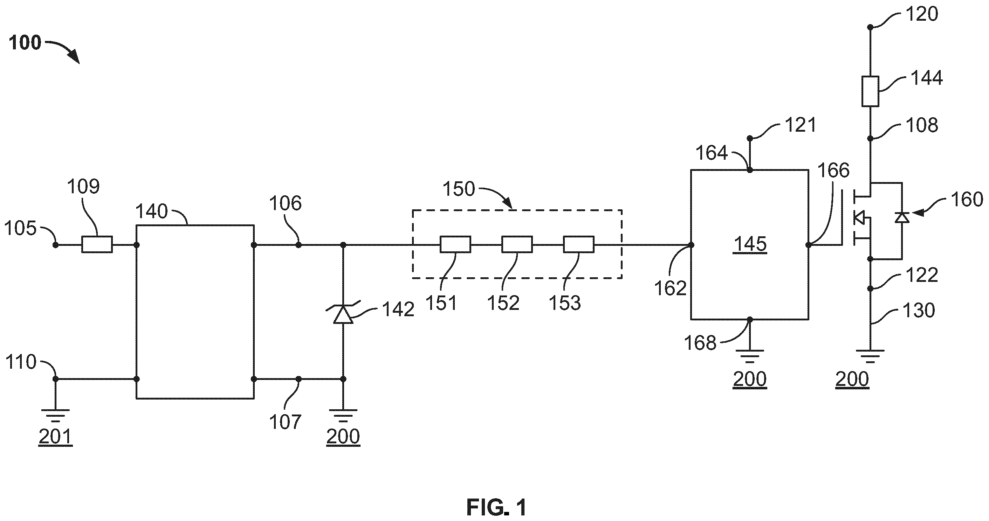

The invention will now be explained in detail with reference to the figures. Figure 1 shows a circuit arrangement 100 according to the present invention. Such a circuit arrangement 100 enables the discharging of an electrical component and can be integrated into different systems. In particular, the circuit arrangement 100 according to the invention enables the discharging of capacitive elements of an electrical component or an electrical network.

The circuit arrangement 100 comprises a first input terminal 105 and a second input terminal 110. As shown in Figure 1, the second input terminal 110 may be connected to ground at a ground terminal 201. However, it is also possible that the second input terminal 110 is not connected to ground. As an example, an extra-low voltage is provided at the first input terminal 105 and at the second input terminal 110. The extra-low voltage advantageously has values between 12 V and 14 V. In an exemplary application, the extra-low voltage between the input terminals is between 3.5 V and 5 V. Depending on the choice of optoisolator, for example, a voltage difference of 1.2 V - 1.8 V may be present between the first input terminal 105 and the second input terminal 110.

The first input terminal 105 and the second input terminal 110 are connected to a first side of a photovoltaic isolation unit 140. This side can be referred to as the control side. On a second side, which is electrically isolated from the first side, the photovoltaic isolation unit 140 is connected to a first intermediate node 106 and a second intermediate node 107. The second side of the isolation unit 140 can be referred to as the load side.

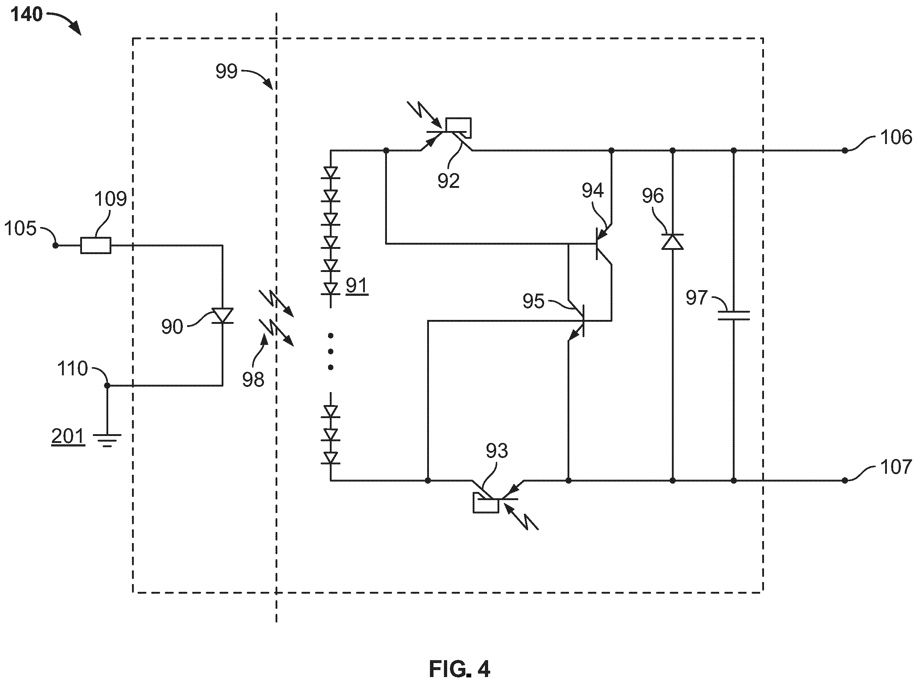

Advantageously, the photovoltaic isolation unit may be formed as an optocoupler or as a photovoltaic optoisolator. An exemplary embodiment of the photovoltaic isolation unit 140 as a photovoltaic optoisolator is shown in **Figure 4.** Figure 4 only shows an example of a photovoltaic optoisolator and corresponds to the model "ACPL-K30T" from Broadcom. It is shown for the sake of completeness and for better understanding.

Figure 4 shows a separation line 99, which represents the galvanic separation of the control side from the load side by the photovoltaic optoisolator. On the control side, the first and second input terminals 105, 110 provide an input voltage. An input resistance 109 for current limiting is also provided at the first input terminal 105. As soon as a sufficiently large current is applied to a light-emitting diode 90 on the control side of the photovoltaic optoisolator, the diode 90 emits beams 98. A series of photodiodes 91 connected in series on the load side of the photovoltaic optoisolator receives the beams 98 and generates a voltage from these beams 98, which can then be tapped at the output nodes of the photovoltaic optoisolator, at the first intermediate node 106 and at the second intermediate node 107. On the load side, the photovoltaic optoisolator 140 also comprises further components, which are arranged between the photodiodes 191 and the output nodes. The photovoltaic optoisolator 140 comprises a first transistor diode 92, a second transistor diode 93, a first transistor 94, a second transistor 95, as well as a diode 96 and a capacitor 97.

Parallel to the photovoltaic isolation unit 140, a first Zener diode 142 is arranged between the first intermediate node 106 and the second intermediate node 107. The first Zener diode 142 advantageously protects the photovoltaic isolation unit 140. In particular, the first Zener diode 142 limits the voltage that is present between the first intermediate node 106 and the second intermediate node 107. If this voltage reaches a value that is greater than the Zener voltage, the onset of current flow at the first Zener diode 142 together with the resistor unit 150 prevents the voltage from increasing further. In this way, the photovoltaic isolation unit 142 is protected on the load side from excessively high voltages.

As an example, the Zener voltage of the first Zener diode 142 is between 8.5 V and 9.5 V, in particular at 9.1 V. However, other values are also possible depending on the area of application of the circuit.

As shown in Figure 1, the second intermediate node 107 may also be connected to the ground terminal 200 and thus be connected to ground. Furthermore, the circuit arrangement 100 comprises a first resistor unit 150, which is arranged between the first intermediate node 106 and a first connection point 162. Advantageously, the first resistor unit 150 comprises a second resistor 151, a third resistor 152 and a fourth resistor 153, which are connected in series. The first resistor unit 150 advantageously serves to limit the current on the load side of the photovoltaic isolation unit. In particular, the second resistor 151, the third resistor 152 and the fourth resistor 153 are high-impedance resistors, such as exemplarily having a value of 1 M ohm. Advantageously, this allows the current at the photovoltaic isolation unit not to exceed 500 µA, in particular not to exceed 300 µA. It is clear that, for the purposes of the present invention, the first resistor unit need not comprise three resistors. A different number of resistors is also possible.

An intermediate circuit 145 is arranged in the circuit arrangement between the first connection point 162, the second connection point 164, the third connection point 166, and the fourth connection point 168.

The second connection point 164 can be connected to a second voltage terminal 121. The fourth connection point 168 can be connected to the ground terminal 200, but a potential different from ground can also be present at the fourth connection point. For example, the second voltage terminal 121 is a load voltage terminal. A low voltage can be, for example, a voltage above a value of 100 V, in particular above 1000 V. In particular, the value of the low voltage at the second voltage terminal 121 is higher than the value of the extra-low voltage at the two input terminals 105, 110.

The third connection point 166 is connected to a first switching element 160. In addition, the first switching element 160 is connected to a third intermediate node 108 and a first output terminal 122.

In one embodiment, the first switching element 160 may comprise a metal oxide semiconductor field effect transistor (MOSFET) and in particular a silicon carbide metal oxide semiconductor field effect transistor (SiC-MOSFET) or an insulated gate bipolar transistor (IGBT) or a junction field effect transistor (JFET). In Figure 1, the first switching element 160 is exemplarily shown as a MOSFET with body diode, but is by no means limited to this embodiment. Preferably, the first switching element 160 comprises a fast-switching switching element which is capable of overload and has low switching losses.

In particular, a gate of the first switching element 160 is connected to the third connection point 166 and a drain of the switching element 160 is connected to the third intermediate node 108. As an example, a source of the switching element 160 is connected to the first output terminal 122.

The first switching element 160 is connected to a first resistor 144 via the third intermediate node 108. The first resistor 144 is also connected to a first voltage terminal 120. A low voltage is present at the first voltage terminal 120, for example. In particular, the low voltage is above 1000V. The first output terminal 122 is exemplarily connected to ground 200 via a path 130. However, it is also possible that the output terminal 122 is not connected to ground, but to a different potential. Depending on the choice of the first switching element 160 and the associated number of source connections, several separate paths can also be provided, each of which connects the source terminals to the other potential, for example ground.

The circuit arrangement 100 according to the present invention enables an electrical component to be discharged from the first voltage terminal 120 via the first resistor 144 and the first switching element 160 to the output terminal 122 and to another potential, for example ground. The term "other potential" is preferably used to illustrate that the potential at the output terminal 122 is different from the potential at the first voltage terminal 120. Advantageously, the first resistor 144 limits the current during discharge.

This discharging is crucial in order to discharge the capacitive loads of the electrical component or the network from low voltage, which is present at the first voltage terminal 120, to an extra-low voltage level in the event of a voltage drop at the input, caused for example by a fault, an accident, or intentional disconnection. In particular, discharging in the sense of the present invention means that a voltage level which is present at the first voltage terminal 120 is discharged to a lower voltage level. It is by no means necessary that a low voltage level at the first voltage terminal 120 is discharged to an extra- low voltage level, but is mentioned here only by way of example for the purpose of explanation.

The mode of operation of the voltage arrangement according to the invention is described below.

When an input voltage is applied between the first and second input terminals 105, 110, the photovoltaic isolation unit 140 generates a voltage at the first and second intermediate nodes 106, 107. For example, if the photovoltaic isolation unit 140 is a photovoltaic optoisolator, the input current causes the light emitting diode 90 on the control side of the optoisolator to emit radiation 98. This radiation 98 is received by the photodiodes 91 on the load side of the photovoltaic optoisolator and a voltage is generated, which is provided between the first intermediate node 106 and the second intermediate node 107. The generated voltage represents a sum of the individual voltages generated by the individual photodiodes.

The operation of the photovoltaic isolation unit 140 and, in particular, the voltage on the load side of the isolation unit 140 is protected by the first Zener diode 142. Due to the advantageous arrangement of the Zener diode 142, the voltage on the load side of the isolation unit 140 is limited to the Zener voltage. This advantageously enables the isolation unit 140 to be protected from excessive voltages even in the event of a fault.

The additional arrangement of the first resistor unit 150 advantageously limits the current on the load side of the photovoltaic isolation unit 140. In the described normal operation, the generated voltage of the isolation unit 140 and the voltage present at the second voltage terminal 121 and at the gate of the first switching element 160 are pulled to ground, or to the potential present at the fourth connection point 168, by the switching element 145. As a result, there is no positive voltage between the gate and source of the first switching element 160 and the first switching element 160 is in the blocking state.

When the voltage at the first and second input terminals 105, 110 on the control side is interrupted, the voltage on the load side of the photovoltaic isolation unit 140 is also reduced. The interruption of the voltage at the first connection point 162 results in the voltage present at the second voltage terminal 121 precharging the gate of the first switching element via the third connection point 166, resulting in a positive gate-source voltage. As a result, the first switching element 160 becomes conductive and a conductive path is created from the first voltage terminal 120, via the first resistor 144 and the first switching element 160 to the output terminal 122. Thus, when the control signal (the voltage at the input terminal) is removed, the voltage applied to the voltage terminal 120 can be discharged. Advantageously, the load, or the voltage, of an electrical component can thus be discharged

The circuit arrangement according to the present invention represents a realization for discharging electrical components, which reliably discharges the component, while having low switching losses and a low quiescent current.

Further advantageous effects of the present invention, such as the even lower-loss switching of the first switching element and/or the fast charging and discharging of the switching element, are realized by advantageous embodiments of the intermediate circuit.

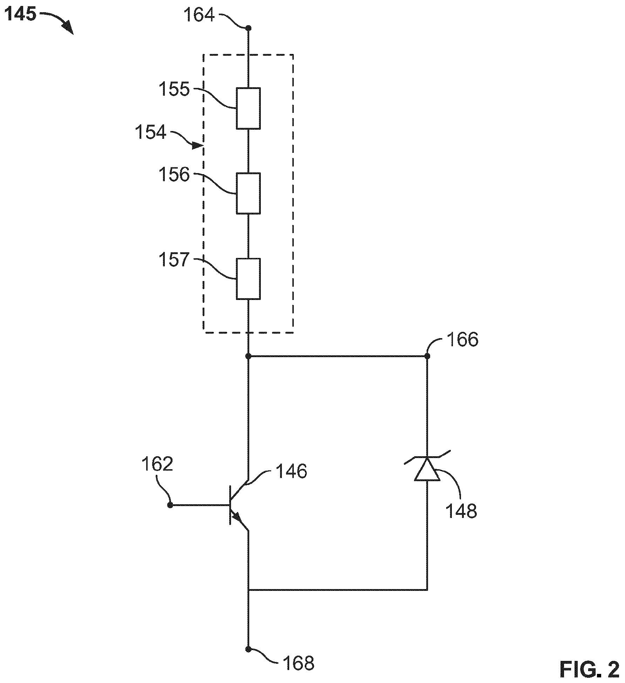

**Fig. 2** **illustrates** the intermediate circuit 145 according to a first advantageous embodiment of the present invention.

The intermediate circuit 145 according to the first embodiment comprises a second resistor unit 154, which is arranged between the second connection point 164 and the third connection point 166. By way of example, the second resistor unit 154 comprises three resistors connected in series, a fifth resistor 155, a sixth resistor 156 and a seventh resistor 157. In addition, the intermediate circuit 145 comprises a second switching element 146 which is arranged between the first connection point 162, the third connection point 166 and the fourth connection point 168. It is clear that, for the purposes of the present invention, the second resistor unit need not comprise three resistors. A different number of resistors is also possible.

A second Zener diode 148 is also arranged between the third connection point 166 and the fourth connection point 168. The intermediate circuit 145 is connected to the gate of the first switching element 160 via the third connection point 166. The second Zener diode is advantageously selected such that it has a high Zener voltage, for example 16 V.

Advantageously, the second resistor unit 154 enables the current applied to the first switching element 160 to be limited. In particular, the fifth resistor 155, the sixth resistor 156 and the seventh resistor 157 are high-impedance resistors, such as having a value of 1 M Ohms.

Advantageously, the second switching element 146 may be a field effect transistor, such as in MOSFET, a SiC MOSFET or a JFET, or a bipolar transistor, such as an IGPT or an NPN transistor or a PNP transistor. The following briefly explains the operation when the second switching element 146 is an FET and when the second switching element 146 is a bipolar transistor. This is intended to illustrate that the advantageous effects of the circuit occur with the different types of transistor.

The operation of the intermediate circuit 145 with a second switching element which is a FET, such as a JFET, is as follows:
As previously described, when a voltage is applied to the input terminals 105, 110, a voltage is generated on the load side of the photovoltaic isolation unit 140. This voltage is applied to the gate of the second switching element 146. As a result, the gate of the second switching element 146 is charged, a positive gate-source voltage is generated and a low impedance path is created between the drain and the source of the second switching element 146. The voltage provided via the second voltage terminal 121, the second connection point 164 and the second resistor unit 154 can thus be discharged via the conductive path created at the second switching element 146.

Due to the resulting low impedance path at the second switching element 146, the gate of the first switching element 160 is not charged via the third connection point 166 and possibly even discharged, and the first switching element 160 is in the blocking state.

When the voltage at the input terminals 105, 110 is removed, the voltage at the first connection point 162 and thus at the gate of the second switching element 146 is also removed. This causes the second switching element 146 to block. The voltage from the second voltage terminal 121 thus charges the gate of the first switching element 160 via the second resistor unit 154. The arrangement of the second Zener diode 148 limits the voltage applied to the third connection point 166 as soon as the second switching element 146 is in the blocked state. This advantageously prevents the voltage at the gate of the first switching element 160 from rising to the level of the applied voltage from the connection point 164. This protects, in particular, the gate of the first switching element 160 and thus the first switching element 160 from excessively high voltages.

As soon as a positive gate-source voltage is present at the first switching element 160, the first switching element 160 becomes conductive. This creates a conductive path between the drain and the source of the first switching element 160 and thus between the first voltage terminal 120, to which the low voltage is applied as an example, and the output terminal 122. This enables the low voltage to be discharged.

This described mode of operation of the intermediate circuit 145 can be transferred in an analogous manner to the mode of operation of the intermediate circuit 145 with a bipolar transistor as the second switching element 146. With bipolar transistors, in contrast to field-effect transistors, it is not decisive that a gate voltage is present, but a base current must be present in order to switch the bipolar transistor to the conducting state.

As an example, the second switching element 146 is an NPN transistor. If a voltage is now present at the input terminals 105, 110, a current is generated at the first connection point 162. A collector current flows through this positive current at the base of the second switching element 146 and a path is created which, analogous to the previous description, dissipates the voltage at the second output terminal 121 and also does not charge the gate of the first switching element 160 via the third connection point 166, but dissipates it against the potential which is present at the fourth connection point 168. When the voltage at the input terminals is removed, analogous to the previous description, there is no longer any current at the first connection point 162 and thus at the base of the first switching element, as a result of which the NPN transistor 146 blocks. As a result, the voltage at the second voltage terminal 121 charges the gate of the first switching element 160. As soon as a positive gate-source voltage is present at the first switching element 160, the first switching element 160 becomes conductive. This creates a conductive path between the drain and the source of the first switching element 160 and thus between the first voltage terminal 120, to which the low voltage is applied as an example, and the output terminal 122.

Furthermore, the intermediate circuit 145 according to the first embodiment enables the discharge of the gate of the first switching element 160 to be improved and, in particular, accelerated. This is necessary so that the first switching element 160 is ready for a new switching operation as quickly as possible after discharging the voltage from the voltage terminal to the output terminal. In addition, switching losses are reduced during accelerated discharging of the gate.

The advantageous arrangement of the second Zener diode 148 limits the voltage present at the third connection point 166 to a value which is high enough to ensure that the first switching element 160 is switched on with low impedance and which is low enough to prevent destruction of the switching element. As an example, the value of the second Zener diode is between 15 V and 20 V. This results in the switching element 160 switching back to the blocking state with lower switching losses. In addition, the second Zener diode 148 together with the second resistor unit 154 protects the first switching element 160 and in particular the gate of the first switching element 160 from excessively high voltages by arranging both components in the form of a voltage divider. In particular, this protects the first switching element 160 from the voltage which is applied to the gate of the first switching element 160 via the second connection point 164 of the second voltage terminal 121.

Thus, the intermediate circuit 145 according to the first embodiment of the present invention enables a more efficient and low-loss switching of the first switching element.

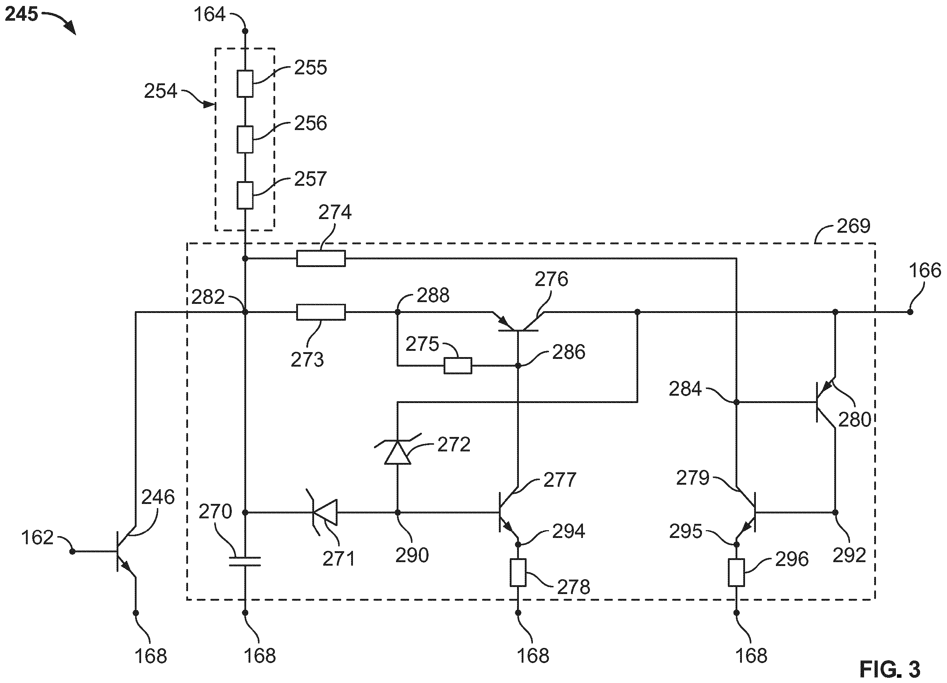

A second advantageous embodiment of the intermediate circuit is shown in Fig. 3. The specifically mentioned embodiments of the first and second intermediate circuits represent exemplary implementations. Of course, the present invention also includes intermediate circuits in a slightly modified form, which are suitable for improving the switching of the first switching element.

The intermediate circuit 245 according to the second embodiment comprises a second resistor unit 254, a second switching element 246 and an acceleration circuit 269. The second resistor unit 254 is arranged between the second connection point 164 and a fourth intermediate node 282. By way of example, the second resistor unit 254 comprises three resistors connected in series, a fifth resistor 255, a sixth resistor 256 and a seventh resistor 257. It is clear that, for the purposes of the present invention, the second resistor unit does not need to comprise three resistors. A different number of resistors is also possible.

The second switching element 246 in the second intermediate circuit 245 is arranged between the first connection point 162, the fourth intermediate node 282 and the fourth connection point 168.

The acceleration circuit 269 is arranged between the fourth intermediate node 282, the third connection point 166 and the fourth connection point 168.

In particular, the acceleration circuit 269 enables more efficient switching of the first switching element 160, which reduces switching losses. The underlying idea is that charge is collected at a capacitor and then transferred to the gate of the first switching element 160. This allows the first switching element to be switched even more efficiently from the blocking state to the conducting state. By additionally optimizing the discharge of the gate of the first switching element, not only the switching on of the first switching element is improved, but also the switching off.

In particular, the acceleration circuit 269 comprises a capacitor 270, which is arranged between the fourth intermediate node 282 and the fourth connection point 168. In addition, the acceleration circuit 269 comprises a plurality of resistors. An eighth resistor 273 is disposed between the fourth intermediate node 282 and the seventh intermediate node 288, and a ninth resistor 274 is disposed between the fourth intermediate node 282 and the fifth intermediate node 284. Further, a tenth resistor 275 is disposed between the seventh intermediate node 288 and the sixth intermediate node 286. An eleventh resistor 278 is arranged between the tenth intermediate node 294 and the fourth connection point 168. In addition, a twelfth resistor 296 is arranged between the eleventh intermediate node 295 and the fourth connection point 168.

Furthermore, the acceleration circuit 269 advantageously comprises a plurality of switching elements. A third switching element 276 is disposed between the seventh intermediate node 288, the sixth intermediate node 286 and the third connection point 166. A fourth switching element 277 is arranged between the sixth intermediate node 286, the eighth intermediate node 290 and the tenth intermediate node 294. In addition, a fifth switching element 279 is arranged between the fifth intermediate node 284, the ninth intermediate node 292 and the eleventh intermediate node 295. A sixth switching element 280 is arranged between the fifth intermediate node 284, the third intermediate node 166 and the ninth intermediate node 292.

Advantageously, the third switching element 276 and/or the fourth switching element 277 and/or the fifth switching element 279 and/or the sixth switching element 280 comprise a MOSFET, in particular a SiC MOSFET, or a JFET or an IGBT or an NPN bipolar transistor, or a PNP bipolar transistor.

Furthermore, the acceleration circuit 269 advantageously comprises a third Zener diode 271, which is arranged between the fourth intermediate node 282 and the eighth intermediate node 290, and a fourth Zener diode 272, which is arranged between the eighth intermediate node 290 and the third connection point 166.

The generation of a voltage at the first and second intermediate nodes 106, 107 via the application of a voltage to the control side of the photovoltaic optoisolation unit 140 is performed as previously described with reference to the acceleration circuit according to the first embodiment.

Depending on the choice of the second switching element, a FET or a bipolar transistor, a distinction must be made as to whether a voltage must be present at the gate of the second switching element 246, or a certain base current.

If the second switching element 246 is a FET and a voltage is applied to the gate of the second switching element 246, then the second switching element 246 switches to a conductive state and provides a path for the voltage applied to the second voltage terminal 121. As a result, the gate of the first switching element 160 is not charged and the first switching element 160 blocks. This has already been described in detail above and it is clear that the mode of operation described above also applies here.

Analogously, the second switching element 246 is switched if the second switching element 246 is a bipolar transistor, in particular an NPN bipolar transistor. A positive base current at the base of the second switching element 246 causes it to switch to the conducting state. The operation of the acceleration circuit described below is independent of the choice of the second switching element 246.

As soon as the control signal on the input side of the photovoltaic optoisolation unit 140 is removed, the second switching element 246 switches back to the blocking state. In this embodiment, the gate of the first switching element 160 is not gradually charged by the voltage at the second voltage terminal 121 until a positive gate-source voltage is applied and the first switching element 160 switches on.

Instead, the voltage at the second voltage terminal 164 first charges the capacitor 270. If there is sufficient charge, this is transferred to the gate of the first switching element 160, causing it to switch on abruptly. In this case, the third switching element 276 controls the fourth switching element 277. This collected charge transfer enables particularly loss-free switching of the first switching element 160. By switching on the first switching element 160, the voltage, in particular the low voltage, at the first voltage terminal 120 can be discharged against the output terminal 122.

In addition, the acceleration circuit 269, in particular through the installation of the fifth switching element 279 and the sixth switching element 280, enables the gate of the first switching element 160 to be subsequently discharged again as quickly as possible and thus without loss. As a result, the first switching element 160 is more efficient and ready again more quickly for a new switching operation. Advantageously, the acceleration circuit 269 according to the present invention reduces the switching time from 50 µs to less than 500 ns.

Values for the components of the acceleration circuit are given below as examples. It is clear that these values are merely examples and represent a possible implementation of the circuit. They are for the purpose of understanding only and are in no way restrictive. As an example, the capacitor has a value between 8 nF and 12 nF, in particular 10 nF.

The third Zener diode 271 has, by way of example, a value between 15 V and 20 V, in particular 18 V, and the fourth Zener diode 272 has, by way of example, a value between 10 V and 15 V, in particular 12 V. Furthermore, the eighth resistor 273 and/or the ninth resistor 274 have exemplary values between 35 ohms and 60 ohms, in particular 47 ohms, but need by no means have the same value. The tenth resistor 275 preferably has a value between 80 k Ohm and 130 k Ohm, in particular 100 k Ohm. The eleventh resistor 276 and/or the twelfth resistor 296 have, by way of example, a value between 3 ohms and 6 ohms, in particular 4.7 ohms, but need by no means have the same value.

As explained, the circuit arrangement according to the present invention thus enables an electrical component to be discharged reliably via a low-loss circuit. In addition, the circuit arrangement is not subject to any mechanical wear effects. The advantageous choice of components also ensures that a high level of electromagnetic compatibility is achieved.

**List of reference numerals:**

| **Reference number** | **Description** |
|---|---|
| 90 | Light-emitting diode on the control side of the photovoltaic isolation unit |
| 91 | Photodiodes on the load side of the photovoltaic isolation unit |
| 92 | First transistor diode of the photovoltaic isolation unit |
| 93 | Second transistor diode of the photovoltaic isolation unit |
| 94 | First transistor of the photovoltaic isolation unit |
| 95 | Second transistor of the photovoltaic isolation unit |
| 96 | Diode of the photovoltaic isolation unit |
| 97 | Capacitor of the photovoltaic isolation unit |
| 98 | Light beams |
| 99 | Galvanic separation line |
| 100 | Circuit arrangement |
| 105 | First input terminal |
| 106 | First intermediate node |
| 107 | Second intermediate node |
| 108 | Third intermediate node |
| 109 | Input resistor |
| 110 | Second input terminal |
| 120 | First voltage terminal |
| 121 | Second voltage terminal |
| 122 | First output terminal |
| 130 | Path |
| 140 | Photovoltaic isolation unit |
| 142 | First Zener diode |
| 144 | First resistor |
| 145, 245 | Intermediate circuit |
| 146, 246 | Second switching element |
| 148 | Second Zener diode |
| 150 | First resistor unit |
| 151 | Second resistor |
| 152 | Third resistor |
| 153 | Fourth resistor |
| 154, 254 | Second resistor unit |
| 155, 255 | Fifth resistor |
| 156, 256 | Sixth resistor |
| 157, 257 | Seventh resistor |
| 160 | First switching element |
| 162 | First connection point |
| 164 | Second connection point |
| 166 | Third connection point |
| 168 | Fourth connection point |
| 200, 201 | Ground terminal |
| 269 | Acceleration circuit |
| 270 | Capacitor |
| 271 | Third Zener diode |
| 272 | Fourth Zener diode |
| 273 | Eighth resistor |
| 274 | Ninth resistor |
| 275 | Tenth resistor |
| 276 | Third switching element |
| 277 | Fourth switching element |
| 278 | Eleventh resistor |
| 279 | Fifth switching element |
| 280 | Sixth switching element |
| 282 | Fourth intermediate node |
| 284 | Fifth intermediate node |
| 286 | Sixth intermediate node |
| 288 | Seventh intermediate node |
| 290 | Eighth intermediate knot |
| 292 | Ninth intermediate node |
| 294 | Tenth intermediate node |
| 295 | Eleventh intermediate node |
| 296 | Twelfth resistor |

## Claims

1. A circuit arrangement (100) for discharging an electrical component; the circuit arrangement (100) comprising:
a photovoltaic isolation unit (140), which is arranged on a first side between a first input terminal (105) and a second input terminal (110) and is arranged on a second side between a first intermediate node (106) and a second intermediate node (107);
a first Zener diode (142), which is arranged between the first intermediate node (106) and the second intermediate node (107);
a first resistor unit (150), which is arranged between the first intermediate node (106) and a first connection point (162);
an intermediate circuit (145), which is arranged between the first connection point (162), a second connection point (164), a third connection point (166) and a fourth connection point (168);
a first switching element (160), which is arranged between the third connection point (166), a third intermediate node (108) and a first output terminal (122); and
a first resistor (144), which is arranged between a first voltage terminal (120) and the third intermediate node (108).

2. Circuit arrangement (100) according to claim 1, wherein the first resistor unit (150) comprises a second resistor (151), a third resistor (152) and a fourth resistor (153).

3. Circuit arrangement (100) according to one of the claims 1 or 2, wherein
the first switching element (160) comprises a silicon carbide metal-oxide semiconductor field effect transistor, SiC-MOSFET, or an insulated gate bipolar transistor, IGBT, or a junction field effect transistor, JFET.

4. Circuit arrangement (100) according to any one of the preceding claims, wherein the second connection point (164) is connected to a second voltage terminal (121); and
wherein the fourth connection point (168) is connected to a ground terminal (200).

5. Circuit arrangement (100) according to any one of the preceding claims, wherein the photovoltaic isolation unit (140) is a photovoltaic optoisolator.

6. Circuit arrangement (100) according to one of the preceding claims, wherein the second voltage terminal (121) and/or the first voltage terminal (120) are a load voltage terminal.

7. Circuit arrangement (100) according to any one of the preceding claims, wherein the first input terminal (105) and the second input terminal (110) are a control voltage terminal.

8. Circuit arrangement (100) according to any one of the preceding claims, wherein the first output terminal (122) is connected to the ground terminal (200).

9. Circuit arrangement (100) according to one of the preceding claims,
wherein the intermediate circuit (145) comprises:
a second resistor unit (154), which is arranged between the second connection point (164) and the third connection point (166);
a second switching element (146), which is arranged between the first connection point (162), the third connection point (166) and the fourth connection point (168); and
a second Zener diode (148), which is arranged between the third connection point (166) and the fourth connection point (168).

10. Circuit arrangement (100) according to one of the preceding claims,
wherein the second resistor unit (154) comprises a fifth resistor (155), a sixth resistor (156) and a seventh resistor (157).

11. Circuit arrangement (100) according to one of the preceding claims,
wherein the second switching element (146) comprises a silicon carbide metal-oxide semiconductor field effect transistor, SiC-MOSFET, or an insulated gate bipolar transistor, IGBT, or a junction field effect transistor, JFET, or an NPN bipolar transistor or a PNP bipolar transistor.

12. Circuit arrangement (100) according to any one of claims 1 to 8, wherein
the intermediate circuit (245) comprises:
a second resistor unit (254), which is arranged between the second connection point (164) and a fourth intermediate node (282);
a second switching element (246), which is arranged between the first connection point (162), the fourth intermediate node (282) and the fourth connection point (168); and
an acceleration circuit (269), which is arranged between the fourth intermediate node (282), the third connection point (166) and the fourth connection point (168).

13. Circuit arrangement (100) according to claim 12, wherein
the second resistor unit (254) comprises a fifth resistor (255), a sixth resistor (256) and a seventh resistor (257).

14. Circuit arrangement (100) according to one of the claims 12 or 13, wherein
the acceleration circuit (269) comprises:
a capacitor (270), which is arranged between the fourth intermediate node (282) and the fourth connection point (168);
an eighth resistor (273), which is arranged between the fourth intermediate node (282) and a seventh intermediate node (288);
a ninth resistor (274), which is arranged between the fourth intermediate node (282) and a fifth intermediate node (284);
a third switching element (276), which is arranged between the seventh intermediate node (288), a sixth intermediate node (286), and the third connection point (166);
a tenth resistor (275), which is arranged between the seventh intermediate node (288) and the sixth intermediate node (286);
a third Zener diode (271), which is arranged between the fourth intermediate node (282) and an eighth intermediate node (290);
a fourth Zener diode (272), which is arranged between the eighth intermediate node (290) and the third connection point (166);
a fourth switching element (277), which is arranged between the sixth intermediate node (286), the eighth intermediate node (290) and the tenth intermediate node (294);
an eleventh resistor (278), which is arranged between the tenth intermediate node (294) and the fourth connection point (168);
a fifth switching element (279), which is arranged between the fifth intermediate node (284), a ninth intermediate node (292), and an eleventh intermediate node (295);
a sixth switching element (280), which is arranged between the fifth intermediate node (284), the third connection point (166) and the ninth intermediate node (292); and
a twelfth resistor (296), which is arranged between the eleventh intermediate node (295) and the fourth connection point (168).

15. Circuit arrangement (100) according to claim 14, wherein
the third switching element (276) and/or the fourth switching element (277) and/or the fifth switching element (279) and/or the sixth switching element (280) comprise a silicon carbide metal-oxide semiconductor field-effect transistor, SiC-MOSFET, or
wherein the third switching element (276) and/or the fourth switching element (277) and/or the fifth switching element (279) and/or the sixth switching element (280) comprise a junction field effect transistor, JFET, or
wherein the third switching element (276) and/or the fourth switching element (277) and/or the fifth switching element (279) and/or the sixth switching element (280) comprise an insulated gate bipolar transistor, IGBT, or
wherein the third switching element (276) and/or the fourth switching element (277) and/or the fifth switching element (279) and/or the sixth switching element (280) comprise an NPN bipolar transistor, or
wherein the third switching element (276) and/or the fourth switching element (277) and/or the fifth switching element (279) and/or the sixth switching element (280) comprise a PNP bipolar transistor.
